# EUROPEAN PATENT SPECIFICATION

(11) **EP 3 124 126 B1**
(45) Date of publication and mention of the grant of the patent: **15.12.2021**
(21) Application number: 15769167.6
(22) Date of filing: 18.03.2015
(51) Int. Cl.: B05D 7/24, B05D 7/00

(54) **METHOD FOR FORMING LANIO3, THIN FILM**
VERFAHREN ZUR BILDUNG EINER LANIO3-DÜNNSCHICHT
PROCÉDÉ DE FORMATION DE FILM MINCE DE LANIO3

(30) Priority: 25.03.2014 JP 2014061622; 24.12.2014 JP 2014260010
(43) Date of publication of application: 01.02.2017
(73) Proprietor: Mitsubishi Materials Corporation, Chiyoda-ku, Tokyo 100-8117 (JP)
(72) Inventor: FUJII Jun, Naka-shi Ibaraki 311-0102 (JP); SAKURAI Hideaki, Naka-shi Ibaraki 311-0102 (JP); SOYAMA Nobuyuki, Naka-shi Ibaraki 311-0102 (JP)
(74) Representative: Gille Hrabal Partnerschaftsgesellschaft mbB Patentanwälte
(86) International application number: PCT/JP2015/057973
(87) International publication number: WO 2015/146729

(56) References cited:
- US-A- 6 146 935
- JIAN-KANG LI ET AL: "The preparation of the single-phase perovskite conductive LaNiO3 films on different substrates", PROCEEDINGS OF SPIE, 8 December 2004 (2004-12-08), pages 184-187, XP55109839, ISSN: 0277-786X, DOI: 10.1117/12.607561
- AI KAMITANI: 'Preparation of ferroelectric thin films on Pt(100)/MgO(100) substrates. (1' DAI 58 KAI EXTENDED ABSTRACTS; October 1997, page 552
- YUICHI MATSUI: 'Thermal Stability of Pt Bottom Electrode for Ferroelectric Capacitor' DAI 58 KAI EXTENDED ABSTRACTS; October 1997, page 552
- None

## Description

### TECHNICAL FIELD

The present invention relates to a method for forming a LaNiO₃ thin film which is used for an electrode of a thin film capacitor, a ferroelectric random access memory (FeRAM) capacitor, a piezoelectric element, a pyroelectric infrared-detecting element, or the like, with a chemical solution deposition (CSD) method.

### BACKGROUND ART

In the related art, in addition to a vacuum deposition method such as a sputtering method, the LaNiO₃ thin film is formed using a chemical solution deposition (CSD) method such as a sol-gel method including: coating a sol-gel solution (liquid composition) in which LaNiO₃ precursors are dissolved in a solvent to form a coating film; and baking the coating film at a predetermined temperature to be crystallized (for example, refer to PTL 1). In the method for forming a transparent conductive thin film described in PTL 1, first, after preparing a coating solution using an aqueous solution in which a lanthanum salt, a nickel salt, and a water-soluble organic binder are dissolved, a base material is coated with the coating solution. Next, the substrate is baked in an oxygen atmosphere at a temperature of 500°C to 800°C. As a result, a thin film which is formed of a metal oxide having a perovskite structure and has a LaNiO₃ composition is obtained and has a thickness which is adjusted such that a volume resistivity at a temperature of 20°C to 800°C is 2×10⁻⁵ Ω·m or lower or such that a surface resistance is 300 Ω/□ or lower. In the method for forming a transparent conductive thin film which is configured as described above, a transparent conductive thin film which is formed of LaNiO₃ having a perovskite structure can be efficiently formed.

Non-patent Literature 1 discloses a method for forming a LaNiO₃ film by coating a substrate surface, which has been coated with a Pt electrode, with a LaNiO₃ thin film forming composition.

Patent Literature 2 discloses a method for forming a capacitor of a semiconductor device. The document describes that the lower electrode is prebaked in predetermined ranges of temperature and time before the dielectric films such as PZT film or TTO film are formed on the lower electrode by a sol-gel method, to remove moisture or contaminants from the surface of the electrode to improve the uniformity and adhesion of the dielectric film.

### CITATION LIST

### PATENT LITERATURE

[PTL 1] Japanese Patent No. 3079262 (Claim 3, paragraph [0011])
[PTL2] US 6 146 935 A

### NON-PATENT LITERATURE

[NPTL 1] Li, J. et al., Proceedings of SPIE, 2004, p. 184-187

### DISCLOSURE OF INVENTION

### TECHNICAL PROBLEM

However, currently, a method for forming a LaNiO₃ thin film using a CSD method such as a sol-gel method has not been adequately established. For example, differences in film-forming conditions such as the kind of solvent contained in a liquid composition or a baking temperature may cause various problems. In the method for forming a transparent conductive thin film of the related art described in PTL 1, a large number of voids are formed in a thin film after baking, and there may be a problem in that a film cannot be uniformly formed. The major cause for the problem is presumed as follows. In particular, in a case where a substrate coated with a Pt electrode is coated with the liquid composition using a spin coating method, the liquid composition used contains a water-soluble component having a large surface tension as a solvent. Therefore, the liquid composition is repelled on the substrate surface, and a large number of pinholes are formed on a coating film after the formation of the coating film. When the film thickness is non-uniform due to the formation of voids, there is a problem in that, for example, the resistivity of the film increases. In consideration of the above-described circumstances, the present inventors discovered the following. By pre-baking a substrate coated with a Pt electrode and coating the substrate with a liquid composition during the formation of a LaNiO₃ thin film using a sol-gel method, no pinholes are formed on a coating film immediately after the formation of the coating film, and thus a LaNiO₃ thin film can be uniformly formed without voids being formed thereon after baking. Based on this, the present invention has been completed.

An object of the present invention is to provide a method for forming a LaNiO₃ thin film having a uniform thickness in which no pinholes are formed on a coating film, and no voids derived from pinholes are formed after baking the coating film.

### SOLUTION TO PROBLEM

According to a first aspect of the present invention, a method for forming a LaNiO₃ thin film is provided, the method comprising:
a step of pre-baking a substrate which is coated with a Pt electrode in an air atmosphere at a temperature of 200 °C or higher for 1 minute or longer to obtain the substrate in which amounts of H₂, H₂O, and CO adsorbed on the substrate surface per 1 cm² are 1 × 10⁻¹⁰ g or less, 2.7 × 10⁻¹⁰ g or less, and 4.2 × 10⁻¹⁰ g or less, respectively;
a step of forming a coating film by coating the pre-baked substrate surface with a LaNiO₃ thin film-forming liquid composition within 60 minutes after the step of pre-baking and drying the LaNiO₃ thin film-forming liquid
a step of pre-baking the coating film; and
a step of forming a LaNiO₃ thin film by baking the pre-baked coating film, wherein the amounts of H₂, H₂O, and CO adsorbed on the substrate surface are measured using thermal decomposition spectroscopy.

According to a second aspect of the invention, in the method for forming a LaNiO₃ thin film according to the first aspect, the LaNiO₃ thin film-forming liquid composition contains one or more organic solvents selected from the group consisting of carboxylic acids, alcohols, esters, ketones, ethers, cycloalkanes, and aromatic compounds.

According to a third aspect of the present invention, in the method for forming a LaNiO₃ thin film according to the first aspect, the LaNiO₃ thin film-forming liquid composition contains an inorganic metal compound and/or an organic metal compound, the inorganic metal compound is a nitrate or a chloride, and the organic metal compound is a carboxylate, a β-diketonate, or an alkoxide.

According to a fourth aspect of the present invention, in the method for forming a LaNiO₃ thin film according to the third aspect, the nitrate is lanthanum nitrate or nickel nitrate, the chloride is lanthanum chloride or nickel chloride, the carboxylate is lanthanum acetate, nickel acetate, lanthanum 2-ethylhexanoate, or nickel 2-ethylhexanoate, the β-diketonate is lanthanum acetylacetonate or nickel acetylacetonate, and the alkoxide is lanthanum isopropoxide.

According to a fifth aspect of the present invention, in the method for forming a LaNiO₃ thin film according to the second aspect, the organic solvent is a single solvent or a mixed solvent of two or more solvents selected from the group consisting of acetic acid, 2-ethylhexanoic acid, ethylene glycol monopropyl ether, ethylene glycol monoisopropyl ether, 3-methoxy-1-butanol, and ethanol.

According to a sixth aspect of the present invention, a method for manufacturing a device is provided, in which the device includes an electrode having a LaNiO₃ thin film which is formed using the method according to any one of the first to fifth aspects, and the device is a composite electronic component which is a thin film capacitor, a capacitor, an IPD, a DRAM memory capacitor, a laminated capacitor, a ferroelectric random access memory capacitor, a pyroelectric infrared-detecting element, a piezoelectric element, an electro-optic element, an actuator, a resonator, an ultrasonic motor, an electric switch, an optical switch, or an LC noise filter element.

According to a seventh aspect of the present invention, in the method for manufacturing a device according to the sixth aspect, the LaNiO₃ thin film is a crystal orientation-controlling layer of a dielectric layer formed in the electrode.

### ADVANTAGEOUS EFFECTS OF INVENTION

In the method for forming a LaNiO₃ thin film according to the first aspect of the present invention, a substrate surface which is coated with Pt electrode is coated, after the step of pre-baking as defined in claim 1 to obtain a substrate in which amounts of H₂, H₂O, and CO adsorbed on the substrate surface per 1 cm² are 1.0×10⁻¹⁰ g or less, 2.7×10⁻¹⁰ g or less, and 4.2×10⁻¹⁰ g or less, respectively, with a LaNiO₃ thin film-forming liquid composition and the LaNiO₃ thin film-forming liquid composition is dried in a state. As a result, a LaNiO₃ thin film having a uniform thickness can be formed in which no pinholes are formed on a coating film immediately after the formation of the coating film, and no voids derived from pinholes are formed after baking the coating film. The reason for this is as follows. By coating the substrate surface with the liquid composition such that the amounts of H₂, H₂O, and CO adsorbed on the substrate surface are 1.0×10⁻¹⁰ g or less, 2.7×10⁻¹⁰ g or less, and 4.2×10⁻¹⁰ g or less, respectively, in a case where the liquid composition contains an ion component such as nitrate ions, an interaction between the ion component and the adsorbates on the Pt surface decreases, and the repellence of the liquid composition on the substrate surface is prevented. As a result, the wettability of the liquid composition on the substrate surface is improved, and the substrate surface can be uniformly coated with the liquid composition.

In the method for forming a LaNiO₃ thin film according to the second aspect of the present invention, the LaNiO₃ thin film-forming liquid composition contains an organic solvent such as a carboxylic acid. Therefore, coating properties are satisfactory.

In the method for forming a LaNiO₃ thin film according to the third aspect, the LaNiO₃ thin film-forming liquid composition contains an inorganic metal compound and/or an organic metal compound, the inorganic metal compound is a nitrate or a chloride, and the organic metal compound is a carboxylate, a β-diketonate, or an alkoxide. Therefore, coating properties are satisfactory.

In the method for forming a LaNiO₃ thin film according to the fourth aspect, the nitrate is lanthanum nitrate or nickel nitrate, the chloride is lanthanum chloride or nickel chloride, the carboxylate is lanthanum acetate, nickel acetate, lanthanum 2-ethylhexanoate, or nickel 2-ethylhexanoate, the β-diketonate is lanthanum acetylacetonate or nickel acetylacetonate, and the alkoxide is lanthanum isopropoxide. Therefore, the uniformity of the composition is satisfactory.

In the method for forming a LaNiO₃ thin film according to the fifth aspect of the present invention, a single solvent such as acetic acid, or a mixed solvent including acetic acid and the like is used as the organic solvent. As a result, even in a case where a composition having a high concentration is used, coating properties are satisfactory.

In the method for manufacturing a device including a LaNiO₃ thin film according to the sixth aspect of the present invention, a LaNiO₃ thin film having no voids and having a uniform thickness which is formed using the above-described film-forming method is used for a capacitor electrode or a piezoelectric electrode of a ferroelectric random access memory. As a result, a device having satisfactory fatigue characteristics is obtained. In addition, a LaNiO₃ thin film which is formed using the above-described film-forming method has translucency, and thus can also be used as an electrode film of a pyroelectric infrared-detecting element.

In the method for manufacturing a device including a LaNiO₃ thin film according to the seventh aspect of the present invention, a LaNiO₃ thin film which is formed using the above-described film-forming method is self-oriented to (100) plane. Therefore, particularly when a thin film capacitor, a piezoelectric element, or the like is manufactured, the LaNiO₃ thin film can also be used as a crystal orientation-controlling layer for controlling the crystal orientation of a dielectric layer of an electrode in the thin film capacitor, the piezoelectric element, or the like.

### BEST MODE FOR CARRYING-OUT THE INVENTION

Next, embodiments of the present invention will be described.

### [Substrate Coated with Pt Electrode]

Examples of a substrate coated with a Pt electrode according to the present invention include: a substrate in which a SiO₂ layer, a Ti layer, and a Pt layer (top layer) are laminated in this order on a Si base material; and a substrate in which a SiO₂ layer, a TiO₂ layer, and a Pt layer (top layer) are laminated in this order on a Si base material. This Pt electrode is formed by sputtering a Pt source in an argon atmosphere at room temperature, by sputtering a Pt source in an argon atmosphere in a state of being heated to a temperature of 300°C to 700°C, or by sputtering a Pt source in an argon atmosphere at room temperature and then heating the Pt in the same atmosphere at a temperature of 300°C to 700°C. In the Pt electrode according to the present invention, the grain growth of Pt occurs by heating, and the surface roughness increases. Therefore, it is preferable that the Pt source be sputtered at room temperature without being heated. In addition, examples of the substrate coated with the Pt electrode include: a substrate in which a SiO₂ layer, an Ir layer, an IrO layer, and a Pt layer (top layer) are laminated in this order on a Si base material; and a substrate in which a SiO₂ layer, a TiN layer, and a Pt layer (top layer) are laminated in this order on a Si base material. Further, examples of the substrate coated with the Pt electrode include: a substrate in which a SiO₂ layer, a Ta layer, and a Pt layer (top layer) are laminated in this order on a Si base material; and a substrate in which a SiO₂ layer, an Ir layer, and a Pt layer (top layer) are laminated in this order on a Si base material. However, the substrate is not limited to the above-described examples as long as it is a substrate in which an insulator layer, an adhesion layer, and a lower electrode are laminated in this order on a base material. On the other hand, in a case where the substrate is used as an electrode of a ferroelectric random access memory capacitor, a piezoelectric element, a pyroelectric infrared-detecting element, or the like, a heat-resistant substrate such as a silicon substrate, a substrate in which SiO₂ is laminated on a Si base material, or a sapphire substrate can be used.

### [Pre-Baking Conditions of Substrate Coated with Pt Electrode and Time Required for Coating of LaNiO₃ Thin Film-Forming Liquid Composition]

Since the substrate coated with the Pt electrode is left to stand in an air atmosphere, components present in the air come into contact with the substrate and are adsorbed on a surface of the substrate. In order to desorb these components from the substrate surface, the substrate is pre-baked. The pre-baking is performed before baking which is performed in a baking step described below. The pre-baking of the substrate according to the present invention is performed by placing the substrate on a hot plate in an air atmosphere at a temperature of 200°C or higher and preferably 200°C to 400°C for 1 minute or longer and preferably 1 minute to 5 minutes, or by putting the substrate in an electric furnace or the like. When the pre-baking is performed in the temperature range and the time range, H₂, H₂O, and CO are desorbed from the substrate surface such that the amount of H₂ is adjusted to be in a range of 1.0×10⁻¹⁰ g or less, the amount of H₂O is adjusted to be in a range of 2.7×10⁻¹⁰ g or less, and the amount of CO is adjusted to be in a range of 4.2×10⁻¹⁰ g or less. A case is assumed in which the substrate surface in this state is coated with a LaNiO₃ thin film-forming liquid composition. In this case, since the amount of H₂, the amount of H₂O, and the amount of CO in the substrate surface are low, a phenomenon in which the surface tension of a solvent of a water-soluble component in the liquid composition is reduced on the substrate surface occurs, and the substrate surface is uniformly coated with the liquid composition. On the other hand, a case is assumed in which the pre-baking temperature and the pre-baking time are less than the above-described lower limits. In this case, the amount of H₂, the amount of H₂O, and the amount of CO adsorbed on the substrate surface are not in the above-described ranges, and when the substrate surface is coated with the LaNiO₃ thin film-forming liquid composition, the above-described phenomenon does not occur. Therefore, the substrate surface is not uniformly coated with the liquid composition, and pinholes are formed in a coating film. The reason for limiting the preferable upper limit value of the pre-baking temperature to 400°C and limiting the preferable upper limit value of the pre-baking time to 5 minutes or shorter is that, even if the pre-baking temperature and the pre-baking time exceed the upper limit values, the above-described desorption effect does not change, and rather heat energy is unnecessarily consumed. The lower the amounts of H₂, H₂O, and CO adsorbed on the substrate surface, the better. However, an extreme decrease in the amount of H₂, the amount of H₂O, and the amount of CO in the substrate surface leads to an increase in cost. Therefore, it is preferable that the amounts of H₂, H₂O, and CO adsorbed on the substrate surface be 2×10⁻¹² g or more, 7.2×10⁻¹¹ or more, and 1.2×10⁻¹⁰ or more, respectively. In addition, although not limited thereto, it is also preferable that the amounts of H₂, H₂O, and CO adsorbed on the substrate surface be 2×10⁻¹² g to 9.8×10⁻¹¹ g, 7.2×10⁻¹¹ to 2.5×10⁻¹⁰ g, and 1.2×10⁻¹⁰ to 3.9×10⁻¹⁰ g, respectively.

### [LaNiO₃ Thin Film-Forming Liquid Composition with which Pre-Baked Substrate is Coated]

The LaNiO₃ thin film-forming liquid composition with which the pre-baked substrate is coated includes LaNiO₃ precursors, an organic solvent, and a stabilizer. A mixing ratio of the LaNiO₃ precursors is preferably 1 mass% to 20 mass% and preferably 3 mass% to 15 mass% in terms of oxides with respect to 100 mass% of the total amount of the LaNiO₃ precursors, the organic solvent, and the stabilizer. A mixing ratio of the stabilizer is higher than 0 mol and 10 mol or lower and preferably 2 mol to 8 mol with respect to 1 mol of the total amount of the LaNiO₃ precursors.

The LaNiO₃ precursors are raw materials for constituting a complex metal oxide (LaNiO₃) in the formed LaNiO₃ thin film. Examples of the LaNiO₃ precursors include metal carboxylates, metal nitrates, metal alkoxides, metal diol complexes, metal triol complexes, metal β-diketonate complexes, metal β-diketoester complexes, metal β-iminoketo complexes, and metal amino complexes of metal elements La and Ni. Specifically, examples of a LaNiO₃ precursor as a La source (hereinafter, also referred to as "La material") include metal carboxylates such as lanthanum acetate, lanthanum octylate, or lanthanum 2-ethylhexanoate; metal nitrates such as lanthanum nitrate; metal alkoxides such as lanthanum isopropoxide; and metal β-diketonate complexes such as lanthanum acetylacetonate. Examples of a LaNiO₃ precursor as a Ni source (hereinafter, also referred to as "Ni material") include metal carboxylates such as nickel acetate, nickel octylate, or nickel 2-ethylhexanoate; metal nitrates such as nickel nitrate; and metal β-diketonate complexes such as nickel acetylacetonate. From the viewpoints of obtaining high solubility in a solvent, storage stability, and the like, it is preferable that at least either the LaNiO₃ precursor as a La source or the LaNiO₃ precursor as a Ni source be an acetate or a nitrate. In a case where the La source or the Ni source is a hydrate, the La source or the Ni source may be dehydrated in advance by heating or the like or may be dehydrated during the synthesis of the precursors by distillation or the like.

The reason for limiting the mixing ratio of the LaNiO₃ precursors (both the La source and the Ni source) to be in a range of 1 mass% to 20 mass% in terms of oxides with respect to 100 mass% of the total amount of the LaNiO₃ precursors, the organic solvent, and the stabilizer is as follows. When the ratio of the LaNiO₃ precursors is lower than 1 mass%, the thickness of the coating film is excessively small, and there is a problem in that cracks may be formed on the film. On the other hand, when the mixing ratio of the LaNiO₃ precursors is higher than 20 mass%, storage stability may deteriorate, for example, the deposition (precipitation) of the precursors occurs. The ratio of the LaNiO₃ precursors in terms of oxides refers to the ratio of metal oxides with respect to 100 mass% of the LaNiO₃ precursors, the organic solvent, and the stabilizer on the assumption that all the metal elements contained in the composition are oxides. In addition, it is preferable that a mixing ratio of the LaNiO₃ precursor as a La source or the LaNiO₃ precursor as a Ni source be adjusted such that a ratio (La/Ni) of La atoms to Ni atoms is 1:1.

On the other hand, as the organic solvent, a single solvent or a mixed solvent of two or more solvents selected from the group consisting of carboxylic acids, alcohols (for example, ethanol, 1-butanol, or polyols other than diol), esters, ketones (for example, acetone or methyl ethyl ketone), ethers (for example, dimethyl ether, diethyl ether, ethylene glycol monopropyl ether, or ethylene glycol monoisopropyl ether), cycloalkanes (for example, cyclohexane or cyclohexanol), and aromatic compounds (for example, benzene, toluene, or xylene) is used. The organic solvent consists of the balance other than the other constituent components in the composition. By adding the organic solvent, the concentration, ratios, and the like of the other constituent components in the composition can be adjusted.

Specifically, preferable examples of carboxylic acids include acetic acid, n-butyric acid, α-methylbutyric acid, i-valeric acid, 2-ethylbutyric acid, 2,2-dimethylbutyric acid, 3,3-dimethylbutyric acid, 2,3-dimethylbutyric acid, 3-methylpentanoic acid, 4-methylpentanoic acid, 2-ethylpentanoic acid, 3-ethylpentanoic acid, 2,2-dimethylpentanoic acid, 3,3-dimethylpentanoic acid, 2,3-dimethylpentanoic acid, 2-ethylhexanoic acid, and 3-ethylhexanoic acid.

In addition, preferable examples of esters include ethyl acetate, propyl acetate, n-butyl acetate, sec-butyl acetate, tert-butyl acetate, isobutyl acetate, n-amyl acetate, sec-amyl acetate, tert-amyl acetate, and isoamyl acetate. Preferable examples of alcohols include ethanol, 1-propanol, 2-propanol, 1-butanol, 2-butanol, 3-methoxy-1-butanol, isobutyl alcohol, 1-pentanol, 2-pentanol, 2-methyl-2-pentanol, and 2-methoxyethanol.

In addition, it is more preferable that, as the organic solvent, a single solvent or a mixed solvent of two or more solvents selected from the group consisting of acetic acid, 2-ethylhexanoic acid, ethylene glycol monopropyl ether, ethylene glycol monoisopropyl ether, 3-methoxy-1-butanol, and ethanol be used.

On the other hand, as the stabilizer, one or more elements selected from the group consisting of β-diketones (such as acetyl acetone, heptafluorobutanoyl pivaloyl methane, dipivaloyl methane, trifluoroacetyl acetone, or benzoyl acetone), β-ketonic acids (such as acetoacetic acid, propionyl acetic acid, or benzoyl acetic acid), β-keto esters (such as methyl, propyl, butyl, and other lower alkyl esters of the above-described ketonic acids), oxy acids (such as lactic acid, glycolic acid, α-oxybutyric acid, or salicylic acid), diols, triols, carboxylic acids, alkanol amines (such as diethanolamine, triethanolamine, monoethanolamine, or N-methylformamide), and polyvalent amines is used. By adding these stabilizers, the storage stability of the composition can be improved. Among these, alkanol amines such as N-methylformamide or diethanolamine are preferable because an effect of improving storage stability is high. The reason for limiting the mixing ratio of the stabilizer to be higher than 0 mol and 10 mol or lower with respect to 1 mol of the total amount of the LaNiO₃ precursors is as follows. When the ratio of the stabilizer is higher than the upper limit value, the thermal decomposition of the stabilizer is delayed, and there is a problem in that cracks are formed on the thin film. It is preferable that the ratio of the stabilizer be 2 mol to 8 mol with respect to 1 mol of the total amount of the LaNiO₃ precursors. Examples of carboxylic acids which are preferable as the stabilizer include acetic acid, octyl acid, and 2-ethylhexanoic acid. In a case where the same carboxylic acid as that of the organic solvent is used as the stabilizer, the upper limit of the ratio of the stabilizer refers to the ratio of the carboxylic acid as the stabilizer. The balance in the composition exceeding the upper limit refers to the ratio of the carboxylic acid as the organic solvent.

In order to obtain the LaNiO₃ thin film-forming liquid composition according to the present invention, first, the LaNiO₃ precursor as a La source and the LaNiO₃ precursor as a Ni source are prepared. These LaNiO₃ precursors are weighed such that the above-described desired metal atomic ratio is obtained. In addition, the stabilizer is prepared and weighed such that the above-described predetermined ratio is obtained with respect to 1 mol of the LaNiO₃ precursors (the total amount of the LaNiO₃ precursor as a La source and the LaNiO₃ precursor as a Ni source). Next, the LaNiO₃ precursor as a Ni source, the organic solvent, and the stabilizer are poured into a reaction vessel and are mixed with each other. In a case where the Ni source is a hydrate, distillation for dehydration may be performed. The LaNiO₃ precursor as a La source is added to the mixture and is heated, preferably, in an inert gas atmosphere at a temperature of 80°C to 200°C for 10 minutes to 2 hours to cause a reaction. As a result, a synthetic solution is prepared. In a case where the La source is a hydrate, distillation for dehydration may be performed. Next, the organic solvent is further added to dilute the precursor concentration to the above-described desired range, and is stirred. As a result, the composition is obtained. After the preparation, in order to suppress temporal changes of the composition, it is preferable that the composition be heated, preferably, in an inert gas atmosphere at a temperature of 80°C to 200°C for 10 minutes to 2 hours.

In the present invention, it is preferable that particles be removed from the composition prepared as above by filtration or the like such that the number of particles having a particle size of 0.5 µm or more (preferably 0.3 µm or more and more preferably 0.2 µm or more) is 50 particles/mL or less per 1 mL of the solution. In order to measure the number of particles in the composition, a light-scattering particle counter is used.

When the number of particles having a particle size of 0.5 µm or more in the composition is more than 50 particles/mL, long-term storage stability deteriorates. The fewer the number of particles having a particle size of 0.5 µm or more in the composition, the better. In particular, the number of particles is preferably 30 particles/mL or less.

A method for treating the prepared composition to obtain the above-described number of particles is not particularly limited. For example, the following methods may be used. A first method is a filtration method for supplying pressure with a syringe using a commercially available membrane filter having a pore size of 0.2 µm. A second method is a pressure filtration method in which a commercially available membrane filter having a pore size of 0.05 µm is combined with a pressure tank. A third method is a circulation filtration method in which the filter used in the second method is combined with a solution-circulating tank.

In all the methods, a particle capture rate by the filter varies depending on a solution supply pressure. It is generally known that, the lower the pressure, the higher the capture rate. Particularly in the first method and the second method, in order to realize the condition that the number of particles having a particle size of 0.5 µm or more is 50 particles or less, it is preferable that the solution be made to pass extremely slowly through the filter at a low pressure.

### [Method for Forming LaNiO₃ Thin Film]

Next, a method of forming a LaNiO₃ thin film according to the present invention will be described. The above-described substrate coated with the Pt electrode is pre-baked under the above-described predetermined conditions. The pre-baked substrate surface coated with the Pt electrode is coated with the LaNiO₃ thin film-forming liquid composition, and the LaNiO₃ thin film-forming liquid composition is dried. As a result, a coating film having a desired thickness is formed. The pre-baked substrate surface is coated with the LaNiO₃ thin film-forming liquid composition within 60 minutes. The coating method is not particularly limited, and examples thereof include spin coating, dip coating, liquid source misted chemical deposition (LSMCD), and electrostatic spray coating. A substrate on which the LaNiO₃ thin film is formed varies depending on the use of the film and the like. For example, in a case where the LaNiO₃ thin film is used as a crystal orientation-controlling layer of a thin film capacitor or the like, a heat-resistant substrate, such as a silicon substrate or a sapphire substrate, on which a lower electrode is formed is used. As the lower electrode which is formed on the substrate, a material, such as Pt, Ir, or Ru, which has conductivity and is not reactive with the LaNiO₃ thin film is used. In addition, for example, a substrate below which a lower electrode is formed with an adhesion layer, an insulating film, and the like interposed therebetween can be used.

After the coating film is formed on the substrate, this coating film is pre-baked and then baked to be crystallized. Pre-baking is performed using a hot plate, a rapid thermal annealing (RTA) device, or the like under predetermined conditions. It is preferable that pre-baking be performed in an air atmosphere, in an oxygen atmosphere or in a water vapor-containing atmosphere in order to remove a solvent and to thermally decompose or hydrolyze a metal compound to be transformed into a complex oxide. Even during heating in an air atmosphere, moisture required for hydrolysis is sufficiently secured with moisture in an air atmosphere. Before pre-baking, particularly in order to remove low-boiling-point components or adsorbed water molecules, a low-temperature heat treatment may be performed using a hot plate at a temperature of 60°C to 120°C for 1 minute to 5 minutes. It is preferable that pre-baking be performed at a temperature of 150°C to 550°C for 1 minute to 10 minutes. In a case where a desired film thickness is obtained by performing the coating process once, the coating process of the composition to the pre-baking process are performed once, and then baking is performed. Alternatively, the coating process of the composition to the pre-baking process are repeated multiple times until a film having a predetermined thickness is obtained. Then, finally, baking is performed in a batch process.

Baking is the process of baking the pre-baked coating film at a crystallization temperature or higher to be crystallized. As a result, a LaNiO₃ thin film is obtained. As a baking atmosphere in this crystallization process, O₂, N₂, Ar, N₂O, H₂, or a mixed gas thereof is preferable. Baking is performed by holding the coating film preferably at 450°C to 900°C for 1 minute to 60 minutes. Baking may be performed using a rapid thermal annealing (RTA) method. A temperature increase rate from room temperature to the baking temperature is preferably 10°C/sec to 100°C/sec.

Through the above-described processes, the LaNiO₃ thin film is obtained. The LaNiO₃ thin film formed as above has a low surface resistivity, superior conductivity and the like, and translucency. Therefore, the LaNiO₃ thin film can be used as, for example, an electrode film of a ferroelectric random access memory capacitor, an electrode film of a piezoelectric element, or an electrode film of a pyroelectric infrared-detecting element. Further, since the LaNiO₃ thin film is self-oriented to (100) plane, the LaNiO₃ thin film can be desirably used as a crystal orientation-controlling layer for preferentially orienting the crystal orientation of a dielectric layer to (100) plane in a thin film capacitor or the like. In addition, in the case of a piezoelectric element, piezoelectric characteristics can be improved.

### Examples

Next, examples of the present invention and comparative examples will be described in detail.

### [Preparation of LaNiO₃ Thin Film-Forming Liquid Composition]

The following composition was prepared as a LaNiO₃ thin film-forming liquid composition. As La materials, lanthanum acetate, lanthanum nitrate, lanthanum chloride, lanthanum acetylacetonate, and lanthanum triisopropoxide were prepared. As Ni materials, nickel acetate, nickel nitrate, nickel chloride, and nickel acetylacetonate were prepared. As organic solvents, acetic acid, 2-ethylhexanoic acid, 3-methoxy-1-butanol, ethanol, ethylene glycol monopropyl ether, and ethylene glycol monoisopropyl ether were prepared. According to each of the compositions shown in Table 1 below, a La material, a Ni material, and an organic solvent were mixed with each other, were dehydrated by distillation, and were mixed with N-methylformamide as a stabilizer in an amount five times the total molar number of La and Ni. Further, the mass of the mixture was adjusted using the same organic solvent as the organic solvent used above. In this way, six LaNiO₃ thin film-forming liquid compositions were prepared. This liquid composition was prepared by mixing the La material and the Ni material with each other such that the liquid composition contains each of metal oxides thereof in an amount of 4 mass% in terms of oxides in which a metal ratio La:Ni was 1:1.

**[Table 1]**

| Composition No. | La Material | Ni Material | Organic Acid |
|---|---|---|---|
| 1 | Lanthanum Acetate | Nickel Acetate | Acetic Acid |
| 2 | Lanthanum Nitrate | Nickel Nitrate | Ethylene Glycol Monopropyl Ether |
| 3 | Lanthanum Chloride | Nickel Chloride | Ethylene Glycol Monoisopropyl Ether |
| 4 | Lanthanum Acetylacetonate | Nickel Acetylacetonate | 3 -Methoxy-1 -Butanol |
| 5 | Lanthanum Triisopropoxide | Nickel Acetate | Ethylene Glycol Monopropyl Ether, Ethanol |
| 6 | Lanthanum 2- Ethylhexanoate | Nickel 2-Ethylhexanoate | 2-Ethylhexanoic Acid |

### [Pre-Baking of Pt Substrate and Formation of LaNiO₃ Thin Film]

### <Example 1>

A SiO₂ layer, a TiO₂ layer, and a Pt layer (top layer) were laminated in this order on a Si base material having a size of 17 mm×17 mm which was oriented to (100) plane. The Pt layer was formed by sputtering a Pt source in an argon atmosphere at room temperature, and then was not heated in an argon atmosphere. The substrate (hereinafter, referred to as "Pt substrate") was placed on a hot plate heated to 300°C for 1 minute and then was pre-baked in the air. After the pre-baking, the Pt substrate was allowed to cool. Next, immediately, molecular species adsorbed on the Pt substrate surface were identified using thermal desorption spectroscopy (hereinafter, referred to as "TDS"). On the other hand, the Pt substrate was pre-baked under the same conditions as described above, and then immediately was moved onto a spin coater so as to be spin-coated with Composition No. 1 shown in Table 1 without being left to stand in the air. Next, the substrate was moved onto a hot plate heated to 65°C, was dried for 1 minute, and was further moved to a hot plate heated to 450°C so as to be pre-baked for 5 minutes. The pre-baked film was rapid-thermally annealed (RTA) to 800°C so as to be baked in an oxygen atmosphere for 5 minutes. As a result, a LaNiO₃ thin film was formed.

### <Example 2>

The same Pt substrate as that of Example 1 was pre-baked using the same hot plate as that of Example 1 at 300°C for 5 minutes and then was allowed to cool. Next, immediately, molecular species adsorbed on the Pt substrate surface were identified using TDS. On the other hand, the Pt substrate was pre-baked under the same conditions as described above, and then immediately was moved onto a spin coater so as to be spin-coated with Composition No. 2 shown in Table 1 without being left to stand in the air. Next, the Pt substrate was dried, pre-baked, and baked under the same conditions as those of Example 1. As a result, a LaNiO₃ thin film was formed.

### <Example 3>

The same Pt substrate as that of Example 1 was pre-baked using the same hot plate as that of Example 1 at 200°C for 1 minute and then was allowed to cool. Next, immediately, molecular species adsorbed on the Pt substrate surface were identified using TDS. On the other hand, the Pt substrate was pre-baked under the same conditions as described above, and then immediately was moved onto a spin coater so as to be spin-coated with Composition No. 3 shown in Table 1 without being left to stand in the air. Next, the Pt substrate was dried, pre-baked, and baked under the same conditions as those of Example 1. As a result, a LaNiO₃ thin film was formed.

### <Example 4>

The same Pt substrate as that of Example 1 was pre-baked using the same hot plate as that of Example 1 at 200°C for 5 minutes and then was allowed to cool. Next, immediately, molecular species adsorbed on the Pt substrate surface were identified using TDS. On the other hand, the Pt substrate was pre-baked under the same conditions as described above, and then immediately was moved onto a spin coater so as to be spin-coated with Composition No. 4 shown in Table 1 without being left to stand in the air. Next, the Pt substrate was dried, pre-baked, and baked under the same conditions as those of Example 1. As a result, a LaNiO₃ thin film was formed.

### <Example 5>

The same Pt substrate as that of Example 1 was pre-baked using the same hot plate as that of Example 1 at 400°C for 1 minute and then was allowed to cool. Next, immediately, molecular species adsorbed on the Pt substrate surface were identified using TDS. On the other hand, the Pt substrate was pre-baked under the same conditions as described above, and then immediately was moved onto a spin coater so as to be spin-coated with Composition No. 5 shown in Table 1 without being left to stand in the air. Next, the Pt substrate was dried, pre-baked, and baked under the same conditions as those of Example 1. As a result, a LaNiO₃ thin film was formed.

### <Example 6>

The same Pt substrate as that of Example 1 was pre-baked using the same hot plate as that of Example 1 at 400°C for 5 minutes and then was allowed to cool. Next, immediately, molecular species adsorbed on the Pt substrate surface were identified using TDS. On the other hand, the Pt substrate was pre-baked under the same conditions as described above, and then immediately was moved onto a spin coater so as to be spin-coated with Composition No. 6 shown in Table 1 without being left to stand in the air. Next, the Pt substrate was dried, pre-baked, and baked under the same conditions as those of Example 1. As a result, a LaNiO₃ thin film was formed.

### <Example 7>

The same Pt substrate as that of Example 1 was pre-baked using the same hot plate as that of Example 1 at 300°C for 1 minute and then was left to stand at 23±2°C in the air of 50±10% for 60 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 1 shown in Table 1. Next, the Pt substrate was dried, pre-baked, and baked under the same conditions as those of Example 1. As a result, a LaNiO₃ thin film was formed.

### <Example 8>

The same Pt substrate as that of Example 1 was pre-baked using the same hot plate as that of Example 1 at 300°C for 5 minutes and then was left to stand at 23±2°C in the air of 50±10% for 60 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 2 shown in Table 1. Next, the Pt substrate was dried, pre-baked, and baked under the same conditions as those of Example 1. As a result, a LaNiO₃ thin film was formed.

### <Example 9>

The same Pt substrate as that of Example 1 was pre-baked using the same hot plate as that of Example 1 at 200°C for 1 minute and then was left to stand at 23±2°C in the air of 50±10% for 60 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 3 shown in Table 1. Next, the Pt substrate was dried, pre-baked, and baked under the same conditions as those of Example 1. As a result, a LaNiO₃ thin film was formed.

### <Example 10>

The same Pt substrate as that of Example 1 was pre-baked using the same hot plate as that of Example 1 at 200°C for 5 minutes and then was left to stand at 23±2°C in the air of 50±10% for 60 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 4 shown in Table 1. Next, the Pt substrate was dried, pre-baked, and baked under the same conditions as those of Example 1. As a result, a LaNiO₃ thin film was formed.

### <Example11>

The same Pt substrate as that of Example 1 was pre-baked using the same hot plate as that of Example 1 at 400°C for 1 minute and then was left to stand at 23±2°C in the air of 50±10% for 60 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 5 shown in Table 1. Next, the Pt substrate was dried, pre-baked, and baked under the same conditions as those of Example 1. As a result, a LaNiO₃ thin film was formed.

### <Example 12>

The same Pt substrate as that of Example 1 was pre-baked using the same hot plate as that of Example 1 at 400°C for 5 minutes and then was left to stand at 23±2°C in the air of 50±10% for 60 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 6 shown in Table 1. Next, the Pt substrate was dried, pre-baked, and baked under the same conditions as those of Example 1. As a result, a LaNiO₃ thin film was formed.

### <Comparative Example 1>

Using the same Pt substrate as that of Example 1 except that it is was not pre-baked, molecular species adsorbed on the Pt substrate surface were identified using TDS. On the other hand, the non-pre-baked Pt substrate was moved onto a spin coater so as to be spin-coated with Composition No. 1 shown in Table 1. Next, the Pt substrate was dried, pre-baked, and baked under the same conditions as those of Example 1. As a result, a LaNiO₃ thin film was formed.

### <Comparative Example 2>

The same Pt substrate as that of Example 1 was pre-baked using the same hot plate as that of Example 1 at 150°C for 5 minutes and then was allowed to cool. Next, immediately, molecular species adsorbed on the Pt substrate surface were identified using TDS. On the other hand, the Pt substrate was pre-baked under the same conditions as described above, and then immediately was moved onto a spin coater so as to be spin-coated with Composition No. 2 shown in Table 1 without being left to stand in the air. Next, the Pt substrate was dried, pre-baked, and baked under the same conditions as those of Example 1. As a result, a LaNiO₃ thin film was formed.

### <Comparative Example 3>

The same Pt substrate as that of Example 1 was pre-baked using the same hot plate as that of Example 1 at 300°C for 5 minutes and then was left to stand at 23±2°C in the air of 50±10% for 90 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 3 shown in Table 1. Next, the Pt substrate was dried, pre-baked, and baked under the same conditions as those of Example 1. As a result, a LaNiO₃ thin film was formed.

### <Comparative Example 4>

The same Pt substrate as that of Example 1 was pre-baked using the same hot plate as that of Example 1 at 200°C for 5 minutes and then was left to stand at 23±2°C in the air of 50±10% for 90 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 4 shown in Table 1. Next, the Pt substrate was dried, pre-baked, and baked under the same conditions as those of Example 1. As a result, a LaNiO₃ thin film was formed.

### <Comparative Example 5>

The same Pt substrate as that of Example 1 was pre-baked using the same hot plate as that of Example 1 at 400°C for 5 minutes and then was left to stand at 23±2°C in the air of 50±10% for 90 minutes. Next, molecular species adsorbed on the Pt substrate surface were identified using TDS. On the other hand, the Pt substrate was pre-baked under the same conditions as described above, was left to stand at 23±2°C in the air of 50±10% for 60 minutes, and then immediately was moved onto a spin coater so as to be spin-coated with Composition No. 5 shown in Table 1. Next, the Pt substrate was dried, pre-baked, and baked under the same conditions as those of Example 1. As a result, a LaNiO₃ thin film was formed.

### [Evaluation]

The amount of desorption gas of molecular species adsorbed on the Pt substrate surface immediate after pre-baking in each of Examples 1 to 12 and Comparative Examples 1 to 5 was measured in a temperature range of 50°C to 400°C using a high-accuracy temperature-programmed desorption gas analyzer (TDS 1200, manufactured by ESCO Ltd.). Based on this measurement, the amount of adsorption of each of H₂, H₂O, and CO was obtained. In addition, regarding each of Examples 1 to 12 and Comparative Examples 1 to 5, whether or not there were pinholes in the dry coating film and whether or not there were voids in the LaNiO₃ thin film were investigated by visual inspection over the entire region of the substrate. The results are shown in Table 2 below.

**[Table 2]**

| Temperature Time | Pt Substrate | | | | | | Coating Film | Thin Film |
|---|---|---|---|---|---|---|---|---|
| | Pre-Baking | | Standing Time After Pre-Baking | Molecular Species Adsorbed on Pt Substrate Surface and Amount of Desorption | | | Pinholes | Voids |
| | | | | H₂ (g/cm²) | H₂O (g/cm²) | CO (g/cm²) | | |
| | Temperature | Time | | | | | | |
| Example 1 | 300°C | 1 min | 0 min | 4.0×10⁻¹² | 9.0 ×10⁻¹¹ | 1.4×10⁻¹⁰ | None | None |
| Example 2 | 300°C | 5 min | 0 min | 2.2×10⁻¹² | 8.1 ×10⁻¹¹ | 1.3×10⁻¹⁰ | None | None |
| Example 3 | 200°C | 1 min | 0 min | 5.0x10⁻¹² | 1.2 ×10⁻¹⁰ | 1.8 ×10⁻¹⁰ | None | None |
| Example 4 | 200°C | 5 min | 0 min | 4.2×10⁻¹² | 9.9 ×10⁻¹¹ | 1.5 ×10⁻¹⁰ | None | None |
| Example 5 | 400°C | 1 min | 0 min | 2.4×10⁻¹² | 8.5 ×10⁻¹¹ | 1.3 ×10⁻¹⁰ | None | None |
| Example 6 | 400°C | 5 min | 0 min | 2.0×10⁻¹² | 7.2 ×10⁻¹¹ | 1.2 ×10⁻¹⁰ | None | None |
| Example 7 | 300°C | 1 min | 60 min | 7.0×10⁻¹¹ | 1.8 ×10⁻¹⁰ | 3.1 ×10⁻¹⁰ | None | None |
| Example 8 | 300°C | 5 min | 60 min | 6.8 ×10⁻¹⁰ | 1.8 ×10⁻¹⁰ | 3.1 ×10⁻¹⁰ | None | None |
| Example 9 | 200°C | 1 min | 60 min | 9.8 ×10⁻¹¹ | 2.5 ×10⁻¹⁰ | 3.9 ×10⁻¹⁰ | None | None |
| Example 10 | 200°C | 5 min | 60 min | 9.6 ×10⁻¹¹ | 2.3 ×10⁻¹⁰ | 3.4 ×10⁻¹⁰ | None | None |
| Example 11 | 400°C | 1 min | 60 min | 6.6×10⁻¹¹ | 1.8 ×10⁻¹⁰ | 2.8 ×10⁻¹⁰ | None | None |
| Example 12 | 400°C | 5 min | 60 min | 6.4 ×10⁻¹¹ | 1.8 ×10⁻¹⁰ | 3.1 ×10⁻¹⁰ | None | None |
| Comparative Example 1 | - | - | - | 2.2 ×10⁻¹⁰ | 4.1 ×10⁻⁹ | 5.9 ×10⁻⁹ | Present | Present |
| Comparative Example 2 | 150°C | 5 min | 0 min | 1.8 ×10⁻¹⁰ | 1.4 ×10⁻⁹ | 2.1 ×10⁻⁹ | Present | Present |
| Comparative Example 3 | 300°C | 5 min | 90 min | 1.6 ×10⁻¹⁰ | 3.2 ×10⁻¹⁰ | 5.6 ×10⁻¹⁰ | Present | Present |
| Comparative Example 4 | 200°C | 5 min | 90 min | 1.8 ×10⁻¹⁰ | 3.6 ×10⁻¹⁰ | 5.9 ×10⁻¹⁰ | Present | Present |
| Comparative Example 5 | 400°C | 5 min | 90 min | 1.6 ×10⁻¹⁰ | 3.2 ×10⁻¹⁰ | 5.3 ×10⁻¹⁰ | Present | Present |

As can be seen from Table 2, in Comparative Example 1 in which pre-baking was not performed, Comparative Example 2 in which the pre-baking temperature was 150°C, and Comparative Examples 3 to 5 in which the standing time after pre-baking was 90 minutes, the amount of H₂ adsorbed on the Pt substrate surface was 1.6×10⁻¹⁰ g/cm² to 2.2×10⁻¹⁰ g/cm², the amount of H₂O adsorbed on the Pt substrate surface was 3.2×10⁻¹⁰ g/cm² to 4.1×10⁻⁹ g/cm², and the amount of CO adsorbed on the Pt substrate surface was 5.3×10⁻¹⁰ g/cm² to 5.9×10⁻⁹ g/cm². In addition, in Comparative Examples 1 to 5, pinholes were formed on the coating film, and voids were formed on the LaNiO₃ thin film. On the other hand, in Examples 1 to 12, in which the pre-baking temperature was 200°C to 400°C, the pre-baking time was 1 minute to 5 minutes, and the standing time after pre-baking was 0 minutes to 60 minutes, the amount of H₂ adsorbed on the Pt substrate surface was 2.0×10⁻¹² g/cm² to 9.8×10⁻¹¹ g/cm², the amount of H₂O adsorbed on the Pt substrate surface was 7.2×10⁻¹¹g/cm² to 2.5×10⁻¹⁰ g/cm², and the amount of CO adsorbed on the Pt substrate surface was 1.2×10⁻¹⁰ g/cm² to 3.9×10⁻¹⁰ g/cm². That is, the amounts of H₂, H₂O, and CO were less than those of Comparative Examples 1 to 5. In addition, in Examples 1 to 12, no pinholes were formed on the coating film, and no voids were formed on the LaNiO₃ thin film. In addition, in the LaNiO₃ thin films of Comparative Examples 1 to 5, convex and concave portions were partially observed by visual inspection. On the other hand, the LaNiO₃ thin films of Examples 1 to 12 had a uniform thickness without convex and concave portions being formed thereon.

### INDUSTRIAL APPLICABILITY

The present invention can be used for manufacturing an electrode in a device, the electrode including a LaNiO₃ thin film, and the device being a composite electronic component such as a thin film capacitor, a capacitor, an IPD, a DRAM memory capacitor, a laminated capacitor, a ferroelectric random access memory capacitor, a pyroelectric infrared-detecting element, a piezoelectric element, an electro-optic element, an actuator, a resonator, an ultrasonic motor, an electric switch, an optical switch, or an LC noise filter element.

## Claims

1. A method for forming a LaNiO₃ thin film, the method comprising:
a step of pre-baking a substrate which is coated with a Pt electrode in an air atmosphere at a temperature of 200 °C or higher for 1 minute or longer to obtain the substrate in which amounts of H₂, H₂O, and CO adsorbed on the substrate surface per 1 cm² are 1 × 10⁻¹⁰ g or less, 2.7 × 10⁻¹⁰ g or less, and 4.2 × 10⁻¹⁰ g or less, respectively;
a step of forming a coating film by coating the pre-baked substrate surface with a LaNiO₃ thin film-forming liquid composition within 60 minutes after the step of pre-baking and drying the LaNiO₃ thin film-forming liquid
a step of pre-baking the coating film; and
a step of forming a LaNiO₃ thin film by baking the pre-baked coating film, wherein the amounts of H₂, H₂O, and CO adsorbed on the substrate surface are measured using thermal decomposition spectroscopy.

2. The method for forming a LaNiO₃ thin film according to Claim 1,
wherein the LaNiO₃ thin film-forming liquid composition contains one or more organic solvents selected from the group consisting of carboxylic acids, alcohols, esters, ketones, ethers, cycloalkanes, and aromatic compounds.

3. The method for forming a LaNiO₃ thin film according to Claim 1,
wherein the LaNiO₃ thin film-forming liquid composition contains an inorganic metal compound and/or an organic metal compound,
the inorganic metal compound is a nitrate or a chloride, and
the organic metal compound is a carboxylate, a β-diketonate, or an alkoxide.

4. The method for forming a LaNiO₃ thin film according to Claim 3,
wherein the nitrate is lanthanum nitrate or nickel nitrate,
the chloride is lanthanum chloride or nickel chloride,
the carboxylate is lanthanum acetate, nickel acetate, lanthanum 2-ethylhexanoate, or nickel 2-ethylhexanoate,
the β-diketonate is lanthanum acetylacetonate or nickel acetylacetonate, and
the alkoxide is lanthanum isopropoxide.

5. The method for forming a LaNiO₃ thin film according to Claim 2,
wherein the organic solvent is a single solvent or a mixed solvent of two or more solvents selected from the group consisting of acetic acid, 2-ethylhexanoic acid, ethylene glycol monopropyl ether, ethylene glycol monoisopropyl ether, 3-methoxy-1-butanol, and ethanol.

6. A method for manufacturing a device,
wherein the device includes an electrode having a LaNiO₃ thin film which is formed using the method according to any one of claims 1 to 5, and
the device is a composite electronic component which is a thin film capacitor, a capacitor, an IPD, a DRAM memory capacitor, a laminated capacitor, a ferroelectric random access memory capacitor, a pyroelectric infrared-detecting element, a piezoelectric element, an electro-optic element, an actuator, a resonator, an ultrasonic motor, an electric switch, an optical switch, or an LC noise filter element.

7. The method for manufacturing a device according to Claim 6,
wherein the LaNiO₃ thin film is a crystal orientation-controlling layer of a dielectric layer formed in the electrode.

## Patentansprüche

1. Verfahren zur Herstellung eines LaNi03-Dünnfilms, wobei das Verfahren umfasst:
einen Schritt des Vorbackens eines Substrats, das mit einer Pt-Elektrode beschichtet ist, in einer Luftatmosphäre bei einer Temperatur von 200°C oder höher für 1 Minute oder länger, um das Substrat zu erhalten, in dem die Mengen an H₂, H₂O und CO, die auf der Substratoberfläche pro 1 cm² adsorbiert sind, 1 × 10⁻¹⁰ g oder weniger, 2,7 × 10⁻¹⁰ g oder weniger bzw. 4,2 × 10⁻¹⁰ g oder weniger betragen;
einen Schritt des Ausbildens eines Beschichtungsfilms durch Beschichten der vorgebackenen Substratoberfläche mit einer einen dünnen LaNiO₃-Film bildenden flüssigen Zusammensetzung innerhalb von 60 Minuten nach dem Schritt des Vorbackens und Trocknen der einen dünnen LaNiO₃-Film bildenden Flüssigkeit
einen Schritt des Vorbackens des Beschichtungsfilms; und
einen Schritt der Ausbildung eines LaNiO₃-Dünnfilms durch Backen des vorgebackenen Beschichtungsfilms,
wobei die Mengen an H2, H₂O und CO, die auf der Substratoberfläche adsorbiert sind, unter Verwendung der thermischen Zersetzungsspektroskopie gemessen werden.

2. Verfahren zur Herstellung eines LaNiO₃-Dünnfilms nach Anspruch 1,
wobei die LaNiO₃-Dünnfilm-bildende flüssige Zusammensetzung ein oder mehrere organische Lösungsmittel enthält, die aus der Gruppe ausgewählt sind, die aus Carbonsäuren, Alkoholen, Estern, Ketonen, Ethern, Cycloalkanen und aromatischen Verbindungen besteht.

3. Verfahren zur Herstellung eines LaNiO₃-Dünnfilms nach Anspruch 1,
wobei die LaNiO₃-Dünnfilm-bildende flüssige Zusammensetzung eine anorganische Metallverbindung und/oder eine organische Metallverbindung enthält,
die anorganische Metallverbindung ein Nitrat oder ein Chlorid ist, und
die organische Metallverbindung ein Carboxylat, ein β-Diketonat oder ein Alkoxid ist.

4. Verfahren zur Herstellung eines LaNi03-Dünnfilms nach Anspruch 3,
wobei das Nitrat Lanthannitrat oder Nickelnitrat ist,
das Chlorid Lanthanchlorid oder Nickelchlorid ist,
das Carboxylat Lanthanacetat, Nickelacetat, Lanthan-2-ethylhexanoat oder Nickel-2-ethylhexanoat ist,
das β-Diketonat Lanthanacetylacetonat oder Nickelacetylacetonat ist, und
das Alkoxid Lanthanisopropoxid ist.

5. Verfahren zur Herstellung eines LaNiO₃-Dünnfilms nach Anspruch 2,
wobei das organische Lösungsmittel ein einzelnes Lösungsmittel oder ein gemischtes Lösungsmittel aus zwei oder mehr Lösungsmitteln ist, ausgewählt aus der Gruppe bestehend aus Essigsäure, 2-Ethylhexansäure, Ethylenglykolmonopropylether, Ethylenglykolmonoisopropylether, 3-Methoxy-1-butanol und Ethanol.

6. Verfahren zur Herstellung einer Vorrichtung,
wobei die Vorrichtung eine Elektrode mit einer LaNiO₃-Dünnschicht enthält, die unter Verwendung des Verfahrens nach einem der Ansprüche 1 bis 5 gebildet wird, und
die Vorrichtung ein zusammengesetztes elektronisches Bauteil ist, das ein Dünnfilmkondensator, ein Kondensator, ein IPD, ein DRAM-Speicherkondensator, ein laminierter Kondensator, ein ferroelektrischer RAM-Speicherkondensator, ein pyroelektrisches Infrarot-Detektorelement, ein piezoelektrisches Element, ein elektrooptisches Element, ein Aktuator, ein Resonator, ein Ultraschallmotor, ein elektrischer Schalter, ein optischer Schalter oder ein LC-Rauschfilterelement ist.

7. Verfahren zur Herstellung einer Vorrichtung nach Anspruch 6,
wobei der LaNiO₃-Dünnfilm eine die Kristallorientierung steuernde Schicht in einer in der Elektrode gebildeten dielektrischen Schicht ist.

## Revendications

1. Procédé pour former un film mince de LaNiO₃, le procédé comprenant :
une étape de précuisson d'un substrat qui est revêtu d'une électrode de Pt dans une atmosphère d'air à une température de 200°C ou plus pendant 1 minute ou plus pour obtenir le substrat dans lequel les quantités de H₂, H₂O, et CO adsorbées sur la surface du substrat par 1 cm² sont de 1 × 10⁻¹⁰ g ou moins, 2,7 × 10⁻¹⁰ g ou moins, et 4,2 × 10⁻¹⁰ g ou moins, respectivement ;
une étape de formation d'un film de revêtement par revêtement de la surface du substrat précuit avec une composition liquide formant un film mince de LaNiO₃ dans les 60 minutes après l'étape de précuisson et de séchage du liquide formant un film mince de LaNiO₃
une étape de précuisson du film de revêtement ; et
une étape de formation d'un film mince de LaNiO₃ par cuisson du film de revêtement précuit,
dans lequel les quantités de H₂, H₂O et CO adsorbées sur la surface du substrat sont mesurées en utilisant la spectroscopie de décomposition thermique.

2. Procédé de formation d'un film mince de LaNiO₃ selon la revendication 1,
dans lequel la composition liquide de formation de film mince de LaNiO₃ contient un ou plusieurs solvants organiques choisis dans le groupe constitué par les acides carboxyliques, les alcools, les esters, les cétones, les éthers, les cycloalcanes et les composés aromatiques.

3. Procédé de formation d'un film mince de LaNiO₃ selon la revendication 1,
dans lequel la composition liquide de formation de film mince de LaNiO₃ contient un composé métallique inorganique et/ou un composé métallique organique,
le composé métallique inorganique est un nitrate ou un chlorure, et
le composé métallique organique est un carboxylate, un -dicétonate, ou un alcoxyde.

4. Procédé de formation d'un film mince de LaNiO₃ selon la revendication 3,
dans lequel le nitrate est le nitrate de lanthane ou le nitrate de nickel,
le chlorure est le chlorure de lanthane ou le chlorure de nickel,
le carboxylate est l'acétate de lanthane, l'acétate de nickel, le 2-éthylhexanoate de lanthane ou le 2-éthylhexanoate de nickel,
le dicétonate est l'acétylacétonate de lanthane ou l'acétylacétonate de nickel, et
l'alcoxyde est l'isopropoxyde de lanthane.

5. Procédé pour former un film mince de LaNiO₃ selon la revendication 2,
dans lequel le solvant organique est un solvant unique ou un solvant mixte de deux solvants ou plus choisis dans le groupe constitué par l'acide acétique, l'acide 2-éthylhexanoïque, l'éther monopropylique d'éthylène glycol, l'éther monoisopropylique d'éthylène glycol, le 3-méthoxy-1-butanol et l'éthanol.

6. Procédé de fabrication d'un dispositif,
dans lequel le dispositif comprend une électrode ayant un film mince de LaNiO₃ qui est formé en utilisant le procédé selon l'une quelconque des revendications 1 à 5, et
le dispositif est un composant électronique composite qui est un condensateur à film mince, un condensateur, un IPD, un condensateur de mémoire DRAM, un condensateur laminé, un condensateur de mémoire vive ferroélectrique, un élément de détection infrarouge pyroélectrique, un élément piézoélectrique, un élément électro-optique, un actionneur, un résonateur, un moteur à ultrasons, un commutateur électrique, un commutateur optique, ou un élément de filtre de bruit LC.

7. Procédé de fabrication d'un dispositif selon la revendication 6,
dans lequel le film mince de LaNiO₃ est une couche de contrôle de l'orientation des cristaux d'une couche diélectrique formée dans l'électrode.
